(19) Europäisches Patentamt / European Patent Office / Office européen des brevets

(11) **EP 4 387 017 B1**

(12) **EUROPEAN PATENT SPECIFICATION**

(45) Date of publication and mention
of the grant of the patent:
**01.10.2025 Bulletin 2025/40**

(21) Application number: **22869822.1**

(22) Date of filing: **01.09.2022**

(51) International Patent Classification (IPC):
*H01S 5/183* (2006.01)    *H01S 5/20* (2006.01)
*H01S 5/30* (2006.01)    *H01S 5/343* (2006.01)

(52) Cooperative Patent Classification (CPC):
**H01S 5/183; H01S 5/18308; H01S 5/18311;
H01S 5/18341; H01S 5/18358; H01S 5/18369;
H01S 5/2009; H01S 5/3095; H01S 5/34333**

(86) International application number:
**PCT/JP2022/032980**

(87) International publication number:
**WO 2023/042675 (23.03.2023 Gazette 2023/12)**

(54) **VERTICAL CAVITY LIGHT-EMITTING ELEMENT**

LICHTEMITTIERENDES ELEMENT MIT VERTIKALEM RESONATOR

ÉLÉMENT ÉLECTROLUMINESCENT À CAVITÉ VERTICALE

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **15.09.2021 JP 2021150595**

(43) Date of publication of application:
**19.06.2024 Bulletin 2024/25**

(73) Proprietor: **Stanley Electric Co. Ltd.
Tokyo 153-8636 (JP)**

(72) Inventor: **KURAMOTO, Masaru
Tokyo 153-8636 (JP)**

(74) Representative: **Schmidbauer, Andreas Konrad
Wagner & Geyer Partnerschaft mbB
Patent- und Rechtsanwälte
Gewürzmühlstrasse 5
80538 München (DE)**

(56) References cited:
JP-A- 2005 353 654    JP-A- 2006 253 635
JP-A- 2008 227 469    JP-A- 2010 123 921
JP-A- 2016 076 539    JP-A- 2016 157 910
JP-A- 2019 208 004    JP-A- 2021 036 553
US-A1- 2002 150 135    US-A1- 2013 028 283

• MISHKAT-UL-MASABIH SAADAT M ET AL:
"Nonpolar GaN-based VCSELs with lattice-
matched nanoporous distributed Bragg reflector
mirrors", SPIE PROCEEDINGS; [PROCEEDINGS
OF SPIE ISSN 0277-786X], SPIE, US, vol. 11280,
16 February 2020 (2020-02-16), pages 112800I -
112800I, XP060128997, ISBN: 978-1-5106-3673-6,
DOI: 10.1117/12.2545030
• SARZALA ROBERT P ET AL: "Metalized
monolithic high-contrast grating as a mirror for
GaN-based VCSELs", PROCEEDINGS OF SPIE;
[PROCEEDINGS OF SPIE ISSN 0277-786X
VOLUME 10524], SPIE, US, vol. 10532, 23
February 2018 (2018-02-23), pages 105321B -
105321B, XP060103376, ISBN:
978-1-5106-1533-5, DOI: 10.1117/12.2289962

**Description**

Technical Field

The present invention is defined in claims 1 and 8, and relates to a vertical cavity light-emitting element, and more particularly to a vertical cavity light-emitting element having multiple quantum well active layers.

Background Art

In a related art, a vertical cavity light-emitting element such as a vertical cavity surface emitting laser (VCSEL) or the like having a structure in which light is resonated vertically to a substrate surface and light is emitted in a direction vertical to the substrate surface is known.

In a vertical cavity light-emitting element, a multiple quantum well (MQW) structure is generally adopted for an active layer in order to obtain emission characteristics having a low threshold current and high efficiency.

Further, for example, Patent Literature 1 describes an edge-emitting nitride semiconductor laser element having a structure aimed at lowering the electrons and hole concentration in a p-side optical guide layer between a final quantum well layer and an electron blocking layer to improve the internal quantum efficiency.

Patent Literature 2 describes a surface-emitting semiconductor laser including first to fourth semiconductor multilayer film reflectors, in which the Al composition or impurity concentration of the semiconductor multilayer film reflectors is adjusted, in order to promote carrier diffusion in the lateral direction at low temperatures.

Patent Literature 3 describes a vertical cavity surface emitting laser aimed at promoting the supply of a current to an active region and reducing a threshold current. The vertical cavity surface emitting laser includes an insulating layer having an opening, a transparent electrode covering the opening, and a reflector made of a dielectric material provided over the opening via the transparent electrode, and a conductive material is provided between the insulating layer and the reflector.

Patent literature 4 describes selectively oxidized vertical cavity lasers emitting at about 1290 nm using InGaAsN quantum wells that operate continuous wave below, at and above room temperature. The lasers employ a semi-insulating GaAs substrate for reduced capacitance, high quality, low resistivity AlGaAs DBR mirror structures, and a strained active region based on InGaAsN. In addition, the design of the VCSEL reduces free carrier absorption of 1.3 mum light in the p-type materials by placing relatively higher p-type dopant concentrations near standing wave nulls.

Citation List

Patent Literatures

Patent Literature 1: Japanese Patent Application Laid-Open No. 2014-131019
Patent Literature 2: Japanese Patent Application Laid-Open No. 2009-194102
Patent Literature 3: Japanese Patent Application Laid-Open No. 2011-29607
Patent literature 4: US Patent Application publication US 2002/150135 A1

Attention is also drawn to a paper by MISHKAT-UL-MASABIH SAADAT MET

AL, entitled "Nonpolar GaN-based VCSELs with lattice-matched nanoporous distributed Bragg reflector mirrors", SPIE PROCEEDINGS; [PROCEEDINGS OF SPIE ISSN 0277-786X], SPIE, US, vol. 11280, 16 February 2020 (2020-02-16), pages 112800I-112800I, ISBN: 978-1-5106-3673-6. The paper presents electrically injected nonpolar m-plane GaN-based VCSELs with lattice-matched nanoporous GaN bottom DBRs and top dielectric DBRs.

Further attention is drawn to the paper by SARZALA ROBERT P ET AL, entitled "Metalized monolithic high-contrast grating as a mirror for GaN-based VCSELs", PROCEEDINGS OF SPIE; [PROCEEDINGS OF SPIE ISSN 0277-786X VOLUME 10524], SPIE, US, vol. 10532, 23 February 2018 (2018-02-23), pages 105321B-105321 B, ISBN: 978-1-5106-1533-5. The paper presents a design of a nitride-based VCSEL emitting at 414 nm. The bottom mirror of the laser is a Al(In)N/GaN DBR (Distributed Bragg Reflector), whereas the top mirror is realized as a semiconductor-metal subwavelength-grating, etched in GaN with silver stripes deposited between the stripes of the semiconductor grating.

Summary of Invention

In accordance with the present invention, a vertical cavity light-emitting element, as set forth in the independent claims 1 and 8 is provided. Embodiments of the invention are defined in the dependent claims.

Technical Problem

In a conventional vertical cavity light-emitting element, further reduction of a threshold current and improvement of light emission efficiency have been problems.

The inventor of the present application has found that improving non-uniformity of holes and electrons in a multiple quantum well active layer leads to a great improvement in element characteristics. The invention of the present application has been made based on such findings, and an object of the present application is to provide a vertical cavity light-emitting element having a low threshold current and high light emission efficiency.

Solution to Problem

A vertical cavity light-emitting element according to one embodiment of the present invention includes a first reflective mirror, an n-type semiconductor layer formed on the first reflective mirror, an active layer made of multiple quantum wells and formed on the n-type semiconductor layer, a final barrier layer formed on a final quantum well of the active layer, an electron blocking layer formed on the final barrier layer, a p-type semiconductor layer formed on the electron blocking layer, a dielectric spacer layer formed on the p-type semiconductor layer, and a second reflective mirror formed on the spacer layer, in which when the number of antinodes and the number of nodes of a standing wave due to light emitted from the active layer, included in the electron blocking layer and the p-type semiconductor layer is zero or one, layer thicknesses of the final barrier layer and the active layer are respectively $H_{fb}$ and $H_{qw}$, a refractive index of the final barrier layer is $n_{fb}$, and an equivalent refractive index of the active layer is $n_{qw}$, the following Expression is satisfied for the active layer and the final barrier layer.

$$\frac{H_{qw}}{2\left(\dfrac{\lambda}{n_{qw}}\right)}+\frac{H_{fb}}{\left(\dfrac{\lambda}{n_{fb}}\right)}\geq 0.4 \qquad \cdot\;\cdot\;\cdot\;(3)$$

where

$$n_{qw}=\frac{\sum n_i \times H_i}{\sum H_i}$$

The above expression is satisfied, and the number of nodes and antinodes of the standing wave included in the final barrier layer is each one or more.

A vertical cavity light-emitting element according to another embodiment of the present invention includes a first reflective mirror, a first n-type semiconductor layer formed on the first reflective mirror, an active layer made of multiple quantum wells and formed on the n-type semiconductor layer, a final barrier layer formed on a final quantum well of the active layer, an electron blocking layer formed on the final barrier layer, a p-type semiconductor layer formed on the electron blocking layer, a tunnel junction layer as a current confinement layer formed on the p-type semiconductor layer, a second n-type semiconductor layer formed by burying the tunnel junction layer, and a second reflective mirror formed on the second n-type semiconductor layer, in which when the number of antinodes and the number of nodes of a standing wave due to light emitted from the active layer, included in the electron blocking layer and the p-type semiconductor layer is zero or one, layer thicknesses of the final barrier layer and the active layer are respectively $H_{fb}$ and $H_{qw}$, a refractive index of the final barrier layer is $n_{fb}$, and an equivalent refractive index of the active layer is $n_{qw}$, the following Expression is satisfied for the active layer and the final barrier layer.

$$\frac{H_{qw}}{2\left(\dfrac{\lambda}{n_{qw}}\right)}+\frac{H_{fb}}{\left(\dfrac{\lambda}{n_{fb}}\right)}\geq 0.4 \qquad \cdot\;\cdot\;\cdot\;(3)$$

where

$$n_{qw} = \frac{\sum n_i \times H_i}{\sum H_i}$$

The above expression is satisfied, and the number of nodes and antinodes of the standing wave included in the final barrier layer is each one or more.

Brief Description of Drawings

FIG. 1 is a sectional diagram schematically illustrating a structure of a vertical cavity surface emitting laser 10 according to a first embodiment of the present invention.
FIG. 2 is a diagram schematically illustrating a band structure of a conduction band of the vertical cavity surface emitting laser 10.
FIG. 3 is a diagram schematically illustrating a standing wave SW in a semiconductor layer from an active layer 15 to a dielectric DBR 25 in the vertical cavity surface emitting laser 10 of Example 1 (Ex. 1).
FIG. 4 is a diagram schematically illustrating the standing wave SW in a semiconductor layer from an active layer to a dielectric DBR in a vertical cavity surface emitting laser of Comparative Example 1 (Cmp. 1).
FIG. 5 is a table illustrating the layer thickness of a semiconductor layer, the number $N_{ND}$ of nodes ND, and the number $N_{AN}$ of antinodes AN of the vertical cavity surface emitting lasers 10 of Examples 1 to 3 (Ex. 1 to Ex. 3) and the vertical cavity surface emitting lasers of Comparative Examples 1 and 2 (Cmp. 1, Cmp. 2).
FIG. 6A is a graph illustrating an optical output with respect to an injection current of the vertical cavity surface emitting laser 10 of Example 1 (Ex. 1).
FIG. 6B is a graph illustrating a voltage with respect to the injection current of the vertical cavity surface emitting laser 10 of Example 1 (Ex. 1).
FIG. 6C is a graph illustrating a differential resistance with respect to the injection current of the vertical cavity surface emitting laser 10 of Example 1 (Ex. 1).
FIG. 7A is a graph illustrating an optical output with respect to an injection current of the vertical cavity surface emitting laser of Comparative Example 1 (Cmp. 1).
FIG. 7B is a graph illustrating a voltage with respect to the injection current of the vertical cavity surface emitting laser of Comparative Example 1 (Cmp. 1).
FIG. 7C is a graph illustrating a differential resistance with respect to the injection current of the vertical cavity surface emitting laser of Comparative Example 1 (Cmp. 1).
FIG. 8A is a diagram illustrating a calculation result of the electron concentration distribution of each well layer at the time of laser oscillation of the surface emitting laser 10 of Example 1.
FIG. 8B is a diagram illustrating a calculation result of the electron concentration distribution of each well layer at the time of laser oscillation of the surface emitting laser of Comparative Example 1.
FIG. 9 is a diagram schematically illustrating the standing wave SW in a semiconductor layer from the active layer 15 to the dielectric DBR 25 in the vertical cavity surface emitting laser 10 of Example 2.
FIG. 10A is a diagram illustrating a calculation result of the electron concentration distribution of each well layer at the time of laser oscillation of the surface emitting laser 10 of Example 2.
FIG. 10B is a diagram illustrating a calculation result of the electron concentration distribution of each well layer at the time of laser oscillation of the surface emitting laser of Comparative Example 2.
FIG. 11 is a diagram illustrating a calculation result of the electron concentration distribution of each well layer at the time of laser oscillation of the surface emitting laser 10 of Example 3.
FIG. 12 is a sectional diagram schematically illustrating a structure of a vertical cavity surface emitting laser 50 according to a second embodiment of the present invention. Description of Embodiments

Hereinafter, preferred embodiments of the present invention will be described. In addition, in the following description and the accompanying drawings, substantially the same or equivalent parts will be described with the same reference numerals.

[First Embodiment]

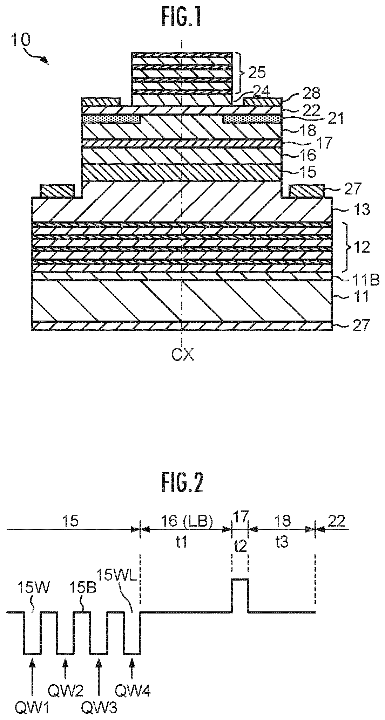

FIG. 1 is a sectional diagram schematically illustrating a structure of the vertical cavity surface emitting laser 10 according to a first embodiment of the present invention. In the present embodiment, the vertical cavity surface emitting laser 10 is a nitride surface light emitting laser made of a GaN (gallium nitride)-based semiconductor layer.
The vertical cavity surface emitting laser 10 is formed by crystal-growing a semiconductor distributed Bragg reflector (DBR) 12, an n-type semiconductor layer 13, the active layer 15 made of multiple quantum wells, a final barrier layer 16, an electron blocking layer (EBL) 17, and a p-type semiconductor layer 18 in this order on a substrate 11.

The substrate 11 is a GaN substrate and is a C-plane GaN substrate inclined by 0.5° in an M-plane direction and 0 ± 0.1° in an A-plane direction from a C-plane.

The crystal growth of the semiconductor layer was performed by metalorganic vapor-phase epitaxy (MOVPE) method. A base GaN layer 11B having a layer thickness of approximately 1 $\mu$m was grown on the substrate 11, and the semiconductor DBR 12, which is a distributed Bragg reflector, was formed on the base GaN layer 11B.

The semiconductor DBR 12 (first reflective mirror) was formed by laminating 42 pairs of n-type GaN films and AlInN films. Each semiconductor film of the semiconductor DBR 12 has a film thickness that is $\lambda/4n$ (n is the refractive index of each semiconductor film) of an emission wavelength $\lambda$ of the active layer 15.

On the semiconductor DBR 12, an n-type semiconductor layer 13 (layer thickness: 350 nm), which is an n-type GaN layer doped with Si (silicon), was grown.

Barrier layers 15B and quantum well layers 15W were alternately formed on the n-type semiconductor layer 13 to form the active layer 15 having 4 quantum well layers 15W. The barrier layer 15B is made of GaInN (layer thickness: 3 nm), and the well layer 15W is made of GaN (layer thickness: 4 nm). The compositions and layer thicknesses of the barrier layer 15B and the well layer 15W can be appropriately selected depending on a desired emission wavelength, emission characteristics, and the like.

On the final well layer 15WL, which is the final layer of the active layer 15, undoped GaN was grown to a layer thickness of 120 nm as the final barrier layer (LB) 16.

Next, the electron blocking layer (EBL) 17 made of Mg (magnesium-doped AlGaN (Al composition: 0.30)) and having a layer thickness of 10 nm was grown. Subsequently, a p-GaN layer was grown to a thickness of 83 nm as the p-type semiconductor layer 18 on the electron blocking layer 17 (p-AlGaN).

The outer periphery of the wafer grown as described above was etched to reach the inside of the n-type semiconductor layer 13 to form a columnar mesa structure.

The outer periphery of the p-type semiconductor layer 18, which is the uppermost semiconductor layer of the mesa structure, was etched to a depth of about 20 nm by dry etching to form a recessed portion, thereby forming the p-type semiconductor layer 18 having a columnar mesa recessed portion.

An insulating film ($SiO_2$) 21 having a thickness of 20 nm for a lateral current and light confinement was deposited in the recessed portion of the p-type semiconductor layer 18 formed by etching. As a result, the recessed portion of the p-type semiconductor layer 18 was flattened, a current confinement structure was formed, and a columnar (central axis: CX) current injection region was formed.

Next, an ITO (indium tin oxide) film having a thickness of 20 nm was formed as a transparent conductive film 22 on the p-type semiconductor layer 18 and the insulating film 21.

Subsequently, a dielectric substance ($Nb_2O_5$) was formed as a spacer layer 24 to a thickness of 38 nm. The spacer layer 24 functions as a phase adjustment layer.

Further, on the spacer layer 24, the dielectric DBR 25 (second reflective mirror) was formed. The dielectric DBR 25 is made of 10.5 pairs of $SiO_2$ (11 layers) and $Nb_2O_5$ (10 layers). It is preferable that the dielectric DBR 25 is formed coaxially with the columnar mesa of the p-type semiconductor layer 18.

Next, an n-electrode 27 was formed on the recessed portion of the outer periphery of the n-type semiconductor layer 13, and a p-electrode 28 was formed on the transparent conductive film 22. Further, the back surface of the substrate 11 was polished to form an AR (anti-reflection) coating 29 made of two layers of $Nb_2O_5/SiO_2$. Through the above steps, the formation of the vertical cavity surface emitting laser 10 has been completed.

The composition and layer thickness of the final barrier layer (LB) 16 described above are merely examples. That is, although the final barrier layer 16 has been described as a GaN layer, a nitride semiconductor layer having different compositions, such as InGaN, AlGaN, InAlGaN, or the like, may be used. Further, although the final barrier layer 16 is an undoped layer, a dopant diffused from the electron blocking layer 17 or the p-type semiconductor layer 18 may be mixed therein.

Further, the composition and layer thickness of the electron blocking layer 17 are merely examples. The electron blocking layer 17 may have a layer thickness of, for example, 3 to 30 nm, and the Al composition may be adjusted within the range of 10 to 70%.

The electron blocking layer 17 has been described as a p-type semiconductor layer (p-AlGaN), but may be a p-type semiconductor layer grown as an i-layer and mixed with a dopant diffused from the p-type semiconductor layer 18.

Further, although the case where the active layer 15 has 4 quantum well layers 15W has been illustrated, it is sufficient if the active layer 15 has a plurality of quantum well layers.

Further, the p-type semiconductor layer 18 may be composed of a plurality of semiconductor layers including layers having mutually different compositions and/or doping concentrations, and an undoped layer. In addition, similarly, the n-type semiconductor layer 13 may be composed of a plurality of semiconductor layers.

Although the case where the dielectric DBR 25 is made of a $SiO_2$ film and a $Nb_2O_5$ film has been illustrated, the dielectric DBR 25 may be composed of dielectric films having different refractive indexes in other combinations. Further, the dielectric DBR 25 may be composed of the semiconductor DBR composed of semiconductor films having different refractive indexes.

FIG. 2 is a diagram schematically illustrating a band structure of a conduction band of the vertical cavity surface emitting laser 10. The band structure from the active layer 15 to the p-type semiconductor layer 18 is illustrated.

The active layer 15 is made of 4 well layers 15W QW1 to QW4 and the barrier layer 15B provided therebetween. The quantum well layer QW4 adjacent to the final barrier layer (LB) 16 is the final well layer 15WL.

The final barrier layer 16 has a layer thickness t1, the electron blocking layer 17 has a layer thickness t2, and the p-type semiconductor layer 18 has a layer thickness t3.

[Conditions for Highly Efficient Vertical Cavity Light-Emitting Element]

The inventors of the present application have obtained knowledge about the conditions that should be met by a vertical cavity light-emitting element with low internal loss and high efficiency.

That is, first, the first interface between a high reflective mirror such as a distributed Bragg reflector (DBR), a diffraction grating, or the like and the inside of a resonator is defined as phase 0" (reference).

Using a refractive index $n_i$ and layer thickness $t_i$ of each layer in the resonator, and the emission wavelength $\lambda$, the total phase information of the standing waves in the resonator is expressed by the following Expression (1).

$$\sum_{i=1}^{n} \frac{t_i}{\left(\dfrac{\lambda}{n_i}\right)} \quad \cdots (1)$$

The synthetic information of standing waves at a predetermined position inside a layer is considered by replacing the thickness from the interface with another layer on the resonator side to a predetermined position with $t_i$.

A first condition is that the number $N_{AN}$ of the antinodes AN and the number $N_{ND}$ of the nodes ND of the standing wave SW included in the p-type semiconductor layer 18 and the electron blocking layer 17, which are p regions, are respectively 0 or 1 ($N_{AN} = 0$ or $N_{AN} = 1$, $N_{ND} = 0$ or $N_{ND} = 1$).

When each layer thickness of the transparent conductive film 22 (ITO), the p-type semiconductor layer 18, and the electron blocking layer 17 is $H_{ITO}$, $H_{GaN}$, $H_{EB}$, each refractive index is $n_{ITO}$, $n_{GaN}$, $n_{EB}$, and the wavelength is $\lambda$, it is preferable that the following Expression (2) is satisfied.

$$\frac{H_{ITO}}{2\left(\dfrac{\lambda}{n_{ITO}}\right)} + \frac{H_{GaN}}{\left(\dfrac{\lambda}{n_{GaN}}\right)} + \frac{H_{EB}}{\left(\dfrac{\lambda}{n_{EB}}\right)} \leq 0.6 \quad \cdots (2)$$

Further, in a second condition, the number of each of the nodes ND and the antinodes AN in the standing wave SW included in the final barrier layer 16 is 1 or more ($N_{ND} \geq 1$ and $N_{AN} \geq 1$).

The number $N_{ND}$ and $N_{AN}$ of nodes ND and antinodes AN of the standing wave SW are calculated by calculating the total phase in the p region and the final barrier layer 16, respectively, by using the above Expression (1), and can be obtained from the number whose phase is $k\pi (k = 1, 2,...)$ in the p region and the final barrier layer 16 and the number whose phase is $(2l - 1)\pi/2 (l = 1, 2,...)$.

Expression (1) = $k/2 (k = 1, 2,...)$ indicates the position where the standing wave becomes the antinode AN, and Expression (1) = $(2l - 1)/4 (l = 1, 2,...)$ indicates the position where the standing wave becomes the node ND. That is, $N_{ND}$ and $N_{AN}$ in the p-type semiconductor layer 18, the electron blocking layer 17, and the final barrier layer 16 are obtained by counting the number of positions where the above-mentioned antinode AN and node ND are included within the lamination range of each layer.

Further, when the layer thicknesses of the final barrier layer 16 and the active layer 15 are $H_{fb}$ and $H_{qw}$, respectively, it is preferable that the following Expression (3) is satisfied. Here, $n_{fb}$ is the refractive index of the final barrier layer 16, and $n_{qw}$ is the equivalent refractive index of the active layer 15.

$$\frac{H_{qw}}{2\left(\dfrac{\lambda}{n_{qw}}\right)} + \frac{H_{fb}}{\left(\dfrac{\lambda}{n_{fb}}\right)} \geq 0.4 \quad \cdots (3)$$

where

$$n_{qw} = \frac{\sum n_i \times H_i}{\sum H_i}$$

Further, (i) it is preferable that the final barrier layer 16 has a layer thickness of λ/4 or more. That is, it is preferable that the following Expression (4) is satisfied.

$$\frac{H_{fb}}{\left(\dfrac{\lambda}{n_{fb}}\right)} \geq \frac{1}{4} \quad \cdot \cdot \cdot (4)$$

Further, (ii) it is preferable that the number of nodes ND included in the final barrier layer 16 is 2 or more ($N_{ND} \geq 2$) and the number of antinodes AN is 1 or more ($N_{AN} \geq 1$). In cases where (i) and (ii) are satisfied, it is preferable that the following Expression (5) is further satisfied.

$$\frac{H_{fb}}{\left(\dfrac{\lambda}{n_{fb}}\right)} \geq \frac{3}{8} \quad \cdot \cdot \cdot (5)$$

Further, it is preferable that the layer thickness of the active layer 15 is λ/8 or less, that is, the following Expression (6) is satisfied. In this case, light confinement loss in the active layer 15 can be reduced.

$$\frac{H_{qw}}{2\left(\dfrac{\lambda}{n_{qw}}\right)} \leq \frac{1}{8} \quad \cdot \cdot \cdot (6)$$

With the above configuration, the electric field strength of light from the p-type semiconductor layer 18 to the electron blocking layer 17 is increased. In addition, the presence of the antinode AN with a high electric field strength of light and at least one node ND in the final barrier layer 16 excites the active layer 15 to the extent that a large optical gain can be obtained.

Furthermore, when the internal light intensity increases due to the semiconductor DBR 12 and the dielectric DBR 25, which are high reflective mirrors, electrons and holes in the final barrier layer 16 are excited by internal light, holes accumulated at the interface between the electron blocking layer 17 and the p-type semiconductor layer 18 are extracted into the active layer 15, and switching-like hole injection into the active layer 15 occurs.

As a result, the uniformity of carriers (electrons and holes) in each of a plurality of well layers 15W of the active layer 15 is improved, and an efficient surface emitting laser can be realized.

[Consideration of Mechanism of Characteristics Improvement]

With the configuration as described above, the uniformity of carriers (electrons and holes) in each of the well layers 15W of the active layer 15 is improved, and an efficient surface emitting laser can be realized. The mechanism by which characteristics such as efficiency and the like can be improved in this way will be discussed.

It is considered that the mechanism of the characteristics improvement is related to the switching injection of holes in order to eliminate carrier non-uniformity in the multiple quantum well. This surface emitting laser is designed so that the antinodes of the standing wave are aligned with the center of the active layer (multiple quantum well). That is, by placing the active layer where the electric field of light is large, the interaction between light and electron-hole recombination is increased.

Therefore, the final barrier layer 16 adjacent to the active layer 15 is in a direction in which the electric field strength of the light is reduced. However, as mentioned above, by placing the final barrier layer 16 where the antinode of the standing wave different from the active layer is located or to include the vicinity of the antinode, it is presumed that the light intensity in this layer increases significantly in the vicinity of a threshold and carriers (electrons and holes) are generated, which has the effect of pulling in the holes on the p-type semiconductor layer 18 side of the electron blocking layer 17 all at once. This pull-in tends to occur when an electric field gradient in the p region is high.

It is considered that this effect is due to an increase in the concentration of holes accumulated on the p-type semiconductor layer 18 side and an increase in the electric field gradient of the electron blocking layer 17. It is considered that the pull-in switching of holes improves the uniformity of carrier distribution in the multiple quantum well and reduces internal loss. Therefore, in some cases, due to laser oscillation, characteristics that cannot be seen in the characteristics of a normal surface emitting laser (VCSEL), such as minimum values of the differential resistance and drive current in the vicinity of the threshold ($dR/dI = 0$, $d^2V/dI^2 = 0$), may be obtained. Therefore, the important factors are the position of the antinode of the final barrier layer 16, the thinning of the p-layer (electron blocking layer 17 and p-type semiconductor layer 18), the strong feedback of light in the vertical direction by a high reflective mirror, and the light intensity such that there is an optical gain.

[Example 1]

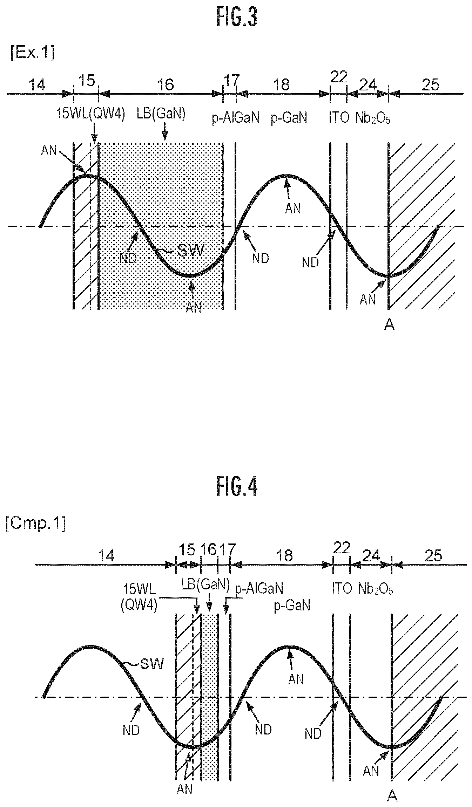

FIG. 3 is a diagram schematically illustrating the standing wave SW of the electric field strength of light emitted from the active layer 15 in the semiconductor layer from the active layer 15 to the dielectric DBR 25 in the vertical cavity surface emitting laser 10 of Example 1 (Ex.1) of the present embodiment.

In Example 1 (Ex. 1), there are one node ND and one antinode AN of the standing wave SW in the final barrier layer 16. That is, if the number of nodes ND is $N_{ND}$ and the number of antinodes AN is $N_{AN}$, then $N_{ND} = 1$ and $N_{AN} = 1$. As illustrated in FIG. 3, a high reflective mirror interface A formed by the dielectric DBR 25 is located at the antinode AN of the standing wave SW.

In addition, there are one node ND and one antinode AN of the standing wave SW ($N_{ND} = 1$, $N_{AN} = 1$) in each of the electron blocking layer (EBL) 17 and the p-type semiconductor layer (p-GaN) 18, which are p regions. Further, it is preferable that there is one node ND of the standing wave SW in the transparent conductive film (ITO) 22 ($N_{ND} = 1$).

With this configuration, the electric field strength from the p-type semiconductor layer 18 to the electron blocking layer 17 is increased. In addition, the presence of the antinode with a high electric field strength of light and at least one node in the final barrier layer 16 excites the active layer 15 to the extent that a large optical gain can be obtained.

Furthermore, when the internal light intensity increases due to the semiconductor DBR 12 and the dielectric DBR 25, which are high reflective mirrors, electrons and holes in the final barrier layer 16 are excited by internal light, holes accumulated at the interface between the electron blocking layer 17 and the p-type semiconductor layer 18 are extracted into the active layer 15, and switching-like hole injection into the active layer 15 occurs.

As a result, the uniformity of carriers (electrons and holes) in the 4 well layers 15W (QW1 to QW4) is improved, and an efficient surface emitting laser can be realized.

[Comparative Example 1]

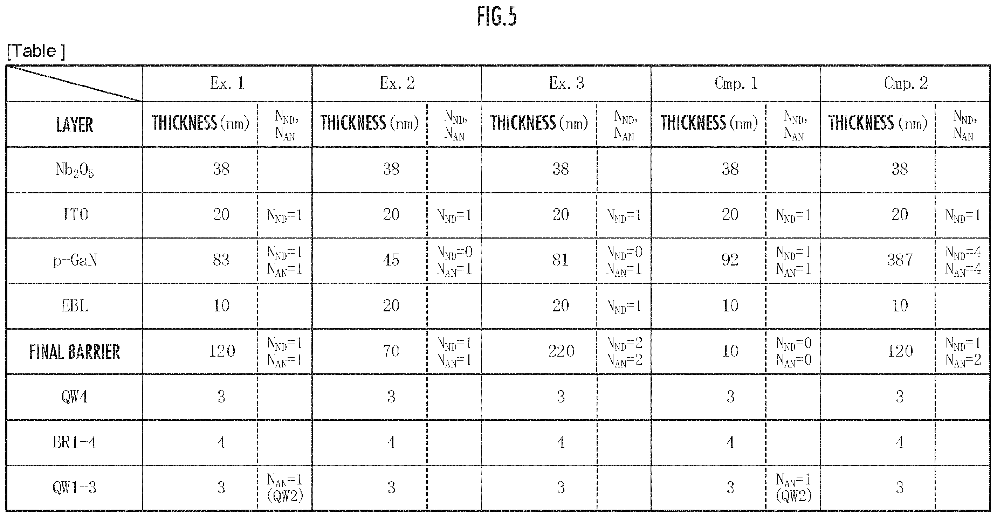

FIG. 4 is a diagram schematically illustrating the standing wave SW of the electric field strength of light in the semiconductor layer from the active layer 15 to the dielectric DBR 25 in the vertical cavity surface emitting laser of Comparative Example 1 (Cmp. 1). In addition, FIG. 5 is a table illustrating the layer thickness of the semiconductor layer, the number $N_{ND}$ of the nodes ND, and the number $N_{AN}$ of the antinodes AN of the vertical cavity surface emitting lasers 10 of Examples 1 to 3 (Ex. 1 to Ex. 3) and the vertical cavity surface emitting lasers of Comparative Examples 1 and 2 (Cmp. 1, Cmp. 2) of the present embodiment.

The vertical cavity surface emitting laser of Comparative Example 1 (Cmp. 1) differs greatly from the vertical cavity surface emitting laser 10 of Example 1 (Ex.1) in that the final barrier layer (LB) 16 has a layer thickness of 10 nm. That is, in the vertical cavity surface emitting laser of Comparative Example 1, there are no nodes ND and antinodes AN of the standing wave SW in the final barrier layer 16 ($N_{ND} = 0$, $N_{AN} = 0$). The configuration is the same as in Example 1 except for the difference in film thickness illustrated in FIG. 5.

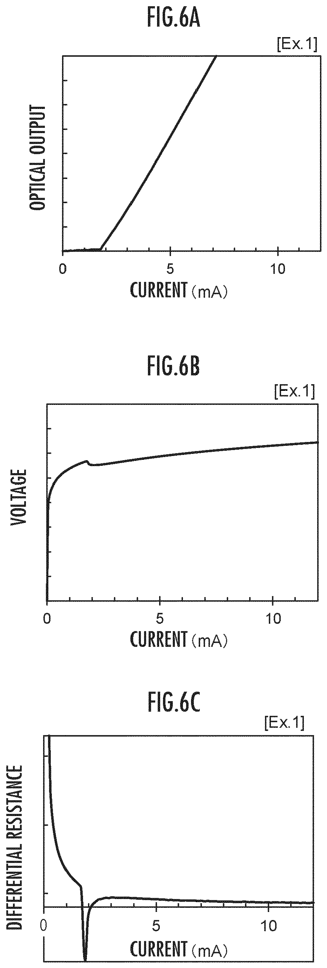

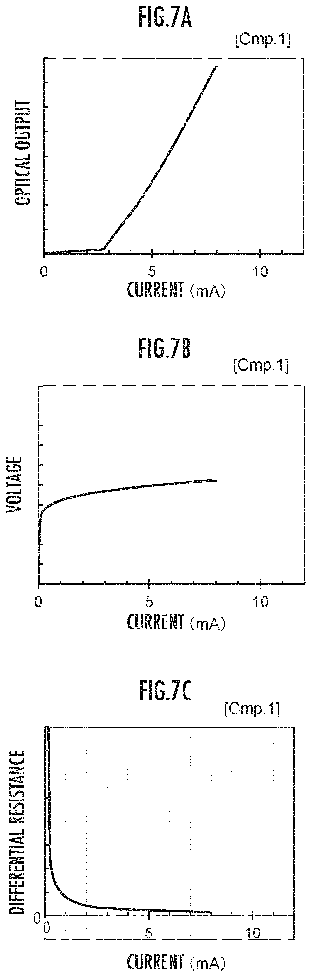

FIGS. 6A, 6B, and 6C are graphs illustrating the measurement results of the vertical cavity surface emitting laser 10 of Example 1 (Ex. 1), illustrating the characteristics of optical output, voltage, and differential resistance with respect to an injection current, respectively. Further, FIGS. 7A, 7B, and 7C are graphs illustrating the measurement results of the vertical cavity surface emitting laser of Comparative Example 1 (Cmp. 1), illustrating the characteristics of optical output, voltage, and differential resistance with respect to the injection current, respectively.

As illustrated in FIG. 6A, laser oscillation characteristics at a low threshold current were confirmed in the vertical cavity surface emitting laser 10 of Example 1 (Ex. 1). Further, as illustrated in Table 1 below, the slope efficiency and external differential quantum efficiency were improved compared to the vertical cavity surface emitting laser of Comparative Example 1 (Cmp.1).

[Table 1]

| | Slope Efficiency (W/A) | External Differential Quantum Efficiency (%) | Internal Loss (cm$^{-1}$) |
|---|---|---|---|
| Example 1 (Ex. 1) | 1.65 | 61 | 8 |
| Comparative Example 1 (Cmp. 1) | 1.5 | 55 | 17 |

As illustrated in Table 1, Comparative Example 1 has lower slope efficiency and external differential quantum efficiency than Example 1. As a result of the analysis, it was found that the internal loss of the laser of Comparative Example 1 was higher than that of Example 1. The internal loss of the laser of Comparative Example 1 was equivalent to the conventionally reported internal loss. Further, the I-V characteristic of Comparative Example 1 also exhibits similar behavior to the I-V characteristic described in the literature of the related art, and in the related art, no minimum value or negative resistance of the differential resistance near the threshold current has been observed.

Specifically, as illustrated in FIGS. 6B and 6C, in the vertical cavity surface emitting laser 10 of the present embodiment, some devices exhibited voltage fluctuations near the threshold current. It was found that the differential resistance suddenly decreases near the threshold current, and the differential resistance and drive current sometimes have minimum values ($dR/dI = 0$, $d^2V/dI^2 = 0$, R: resistance, I: current). Further, in more severe cases, the differential resistance may enter a negative region.

Such characteristics are not found in conventional surface emitting lasers. In the vertical cavity surface emitting laser 10 of the present embodiment, in a state where the p region (electron blocking layer 17 and p-type semiconductor layer 18) is thin and a large electric field is applied to the p-region layer, it is considered that the holes accumulated at the interface between the electron blocking layer 17 and the p-type semiconductor layer 18 (p-GaN) are induced by the electrons and holes generated in the final barrier layer 16 and flow into the active layer 15 all at once. This promotes carrier concentration uniformity between multiple quantum wells, improves internal loss, external differential quantum efficiency, and slope efficiency, and reduces the differential resistance near the threshold current and obtains a minimum value.

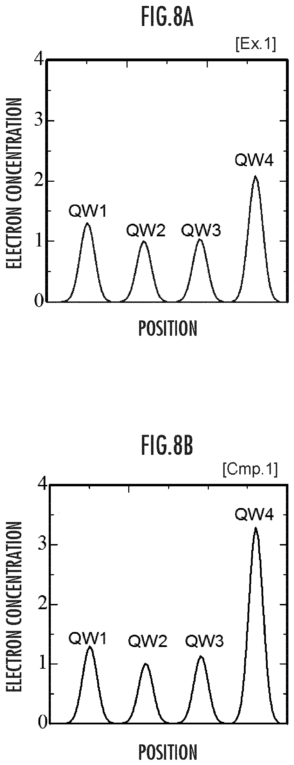

More specifically, it is considered that the reduction in internal loss is due to uniform distribution of carrier density in each well layer 15W. FIGS. 8A and 8B illustrate calculation results of the carrier density (electron concentration) distribution of each well layer 15W during laser oscillation of the surface emitting lasers of Example 1 and Comparative Example 1, respectively.

FIGS. 8A and 8B illustrate the electron concentration normalized with the well layer (QW2) having the lowest carrier density set to 1. It can be seen that in Comparative Example 1, the non-uniformity is 3 times or more, but in Example 1, the non-uniformity is suppressed to about twice. This non-uniformity causes optical loss in the well layer (QW2) having the lowest carrier density, which is considered to increase internal loss.

In conventional surface emitting lasers, the reason why the external differential quantum efficiency is low and the differential resistance before laser oscillation is high is considered to be that holes with a large effective mass and the presence of a piezoelectric field make it difficult for holes to move and the non-uniformity of holes and electrons occurs within a multiple quantum well layer.

In Comparative Example 1, in the p region (electron blocking layer 17 and p-type semiconductor layer 18), there is one node ND and one antinode AN ($N_{ND} = 1$, $N_{AN} = 1$), and the first condition is satisfied, but there is no node ND and antinode AN in the final barrier layer 16 ($N_{ND} = 0$, $N_{AN} = 0$), and the second condition is not satisfied. It is important to satisfy the first condition and the second condition.

As a result of the effects described above, in the vertical cavity surface emitting laser 10 of the present embodiment, an effect of reducing internal loss is obtained, and a reduction in differential resistance occurs near the threshold current. Further, in some cases, the differential resistance and drive current have minimum values ($dR/dI = 0$, $d^2V/dI^2 = 0$) near the threshold current.

The emission spectrum and gain spectrum before laser oscillation can be widely distributed on a high energy side according to the Fermi-Dirac distribution function, and it is preferable to have a gain peak and an emission peak on the higher energy (shorter wavelength) side than an oscillation wavelength. Further, it is also preferable to make the well layer thick, for example, 4 nm or more so that a second level (a quantum level in the conduction band) is formed in the quantum well.

Whether the emission peak is on the high energy side can be confirmed by checking the optical spectrum before oscillation and observing that the light intensity or energy is greater on the shorter wavelength side than the oscillation wavelength. In addition, by utilizing this hole injection effect and performing optical excitation while keeping the current fixed at the current before laser oscillation, it is easy to cause an optical switch phenomenon, and it is also possible to cause self-pulsation operation in a surface emitting laser.

In a case where the optical switch phenomenon is used, a current slightly below the threshold current is supplied by a power supply (not shown) connected to the vertical cavity surface emitting laser 10, and light is irradiated onto the vertical cavity surface emitting laser 10 from the outside. External light can be irradiated by using a light source different from the vertical cavity surface emitting laser 10.

[Example 2]

In Example 1 (Ex. 1), the case has been described in which there are one node ND and one antinode AN of the standing wave SW in the final barrier layer 16 ($N_{ND} = 1$, $N_{AN} = 1$) and there are one node ND and one antinode AN in the p region (electron blocking layer 17 and p-type semiconductor layer 18) ($N_{ND} = 1$, $N_{AN} = 1$).

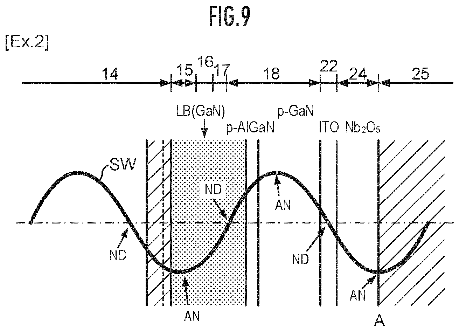

The structure of the vertical cavity surface emitting laser 10 of Example 2 (Ex. 2) will be described with reference to FIG. 9. FIG. 9 is a diagram schematically showing the standing wave SW of the electric field strength of light in the semiconductor layer from the active layer 15 to the dielectric DBR 25 in the vertical cavity surface emitting laser 10 of Example 2.

As illustrated in FIG. 5, in Example 2, the layer thickness of the final barrier layer 16 is 70 nm, which is thinner than 120 nm in Example 1. Further, the layer thickness of the p region (the total layer thickness of the electron blocking layer 17 and the p-type semiconductor layer 18) is 65 nm (20 + 45 nm), which is thinner than 93 nm (10 + 83 nm) in Example 1.

In addition, the Al composition of the electron blocking layer 17 was set to 0.15. The same applies to Example 1 except for the above points.

In the vertical cavity surface emitting laser 10 of Example 2, there are one node ND and one antinode AN in the final barrier layer 16 ($N_{ND} = 1$, $N_{AN} = 1$), there is one antinode AN in the p region (electron blocking layer 17 and p-type semiconductor layer 18), and there is no node ND ($N_{AN} = 1$, $N_{ND} = 0$).

[Comparative Example 2]

The vertical cavity surface emitting laser of Comparative Example 2 (Cmp. 2) differs greatly from the vertical cavity surface emitting laser 10 of Example 1 (layer thickness of p region: 93 nm) and Example 2 (layer thickness of p region: 65 nm) in that the layer thickness of the p region (total layer thickness of electron blocking layer 17 and p-type semiconductor layer 18) is as thick as 397 nm (10 + 387 nm). The same applies to Example 1 except for the above points.

As illustrated in FIG. 5, in the vertical cavity surface emitting laser of Comparative Example 2, there are one node ND and two antinodes AN of the standing wave SW in the final barrier layer 16 ($N_{ND} = 1$, $N_{AN} = 2$). In addition, in the p region (electron blocking layer 17 and p-type semiconductor layer 18), there are 4 nodes ND and 4 antinodes AN ($N_{ND} = 4$, $N_{AN} = 4$).

That is, the second condition described above (the number of nodes ND and antinodes AN included in the final barrier layer 16) is satisfied, but the first condition (the number of nodes ND and antinodes AN included in the electron blocking layer 17 and the p-type semiconductor layer 18) is not satisfied.

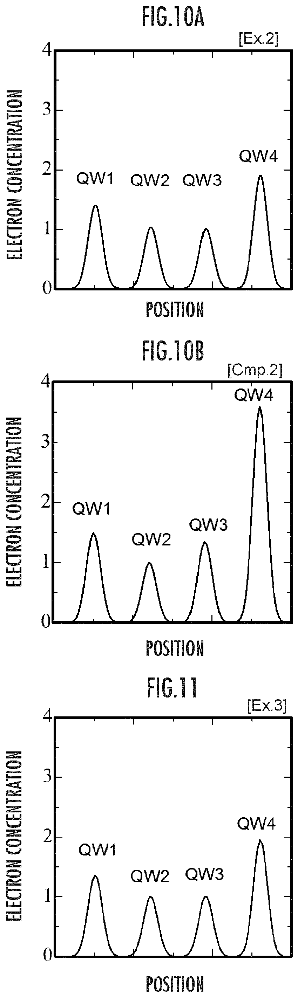

FIGS. 10A and 10B illustrate calculation results of the carrier density (electron concentration) distribution of each well layer 15W during laser oscillation of the surface emitting lasers of Example 2 and Comparative Example 2, respectively.

FIGS. 10A and 10B illustrate the electron concentration normalized with the well layer (QW2) having the lowest carrier density set as 1. It can be seen that in Comparative Example 2, the non-uniformity is 3.5 times or more, but in Example 2, the non-uniformity is suppressed to about twice.

This non-uniformity causes optical loss in the well layer (QW2) having the lowest carrier density, which is considered to increase internal loss.

From the above, it can be seen that an efficient surface emitting laser cannot be obtained simply by satisfying the condition for the final barrier layer (second condition).

Further, the homogeneity of carriers in Example 2 is slightly higher than that in Example 1, and $N_{ND} = 0$ and $N_{AN} = 1$ are preferable to $N_{ND} = 1$ and $N_{AN} = 1$ in the electron blocking layer 17 and the p-type semiconductor layer 18.

[Example 3]

As illustrated in FIG. 5, in Example 3 (Ex. 3), the layer thickness of the final barrier layer 16 is 220 nm, which is thicker than 120 nm in Example 1. The layer thickness of the p region (total layer thickness of the electron blocking layer 17 and the p-type semiconductor layer 18) is 101 nm (20 + 81 nm), which is thicker than 93 nm (10 + 83 nm) in Example 1. In addition, the Al composition of the electron blocking layer 17 was set to 0.15. The same applies to Example 1 except for the above points.

In Example 3, reflecting the fact that the final barrier layer 16 is thick, there are 2 nodes ND and 2 antinodes AN in the final barrier layer 16 ($N_{ND} = 2$, $N_{AN} = 2$). Further, in the p region (electron blocking layer 17 and p-type semiconductor layer 18), there is one node ND and one antinode AN ($N_{ND} = 1$, $N_{AN} = 1$).

FIG. 11 illustrates calculation results of the carrier density (electron concentration) distribution of each well layer 15W during laser oscillation of the surface emitting laser 10 of Example 3.

It was confirmed that the uniformity was significantly improved compared to Comparative Examples 1 and 2. Further, in Example 3, the uniformity was slightly improved compared to Example 1, and it was found that it was possible to realize the targeted highly efficient surface emitting laser even in a configuration in which the number of antinodes AN and nodes ND in the final barrier layer was increased, that is, in a configuration in which the number of $N_{ND}$ and/or $N_{AN}$ was 2 or more.

Therefore, there is no effect in a case where the number of antinodes AN and nodes ND in the final barrier layer is insufficient (Comparative Example 1) or in a case where the number of antinodes AN and nodes ND in the p region is too large (Comparative Example 2), but in a case where the first and second conditions described above are satisfied, switching of hole injection occurs, and it is possible to eliminate the reduction in efficiency of the surface emitting laser due to carrier non-uniformity between the well layers of the quantum well active layer, and provide a highly efficient surface emitting laser.

[Second Embodiment]

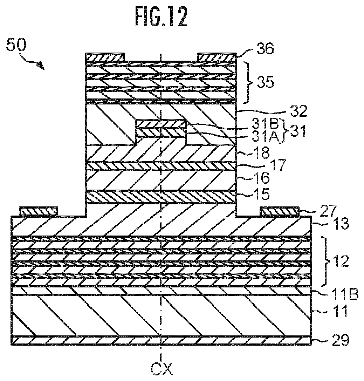

FIG. 12 is a sectional diagram schematically illustrating a structure of a vertical cavity surface emitting laser 50 according to a second embodiment of the present invention. The vertical cavity surface emitting laser 50 of the present embodiment has a tunnel junction as a current confinement structure.

The vertical cavity surface emitting laser 50 is a nitride surface light emitting laser having the same configuration as Example 1 of the vertical cavity surface emitting laser 10 according to the first embodiment.

That is, the vertical cavity surface emitting laser 50 is formed by crystal-growing a semiconductor DBR 12, an n-type semiconductor layer 13, the active layer 15 made of multiple quantum wells, a final barrier layer 16, an electron blocking layer (EBL) 17, and a p-type semiconductor layer 18 in this order on the substrate 11. In addition, the composition, layer thickness, impurity concentration, and the like of each semiconductor layer are the same as those of the vertical cavity surface emitting laser 10.

In the vertical cavity surface emitting laser 50 according to the second embodiment, after the p-type semiconductor layer 18 is grown, a tunnel junction layer 31 made of a p-type semiconductor layer 31A of $p^+$-GaN with a high impurity concentration and an n-type semiconductor layer 31B of $n^+$-GaN with a high impurity concentration is grown.

Next, the tunnel junction layer 31 and the p-type semiconductor layer 18 are etched into a columnar shape from the upper surface of the tunnel junction layer 31 to the inside of the p-type semiconductor layer 18 to form a columnar mesa structure.

For example, the layer thickness of the tunnel junction layer 31 is 20 nm, and the diameter of the columnar mesa structure is 4 $\mu$m (central axis CX). In addition, the mesa structure is formed by using dry etching, and the tunnel junction layer 31 and the p-type semiconductor layer 18 are etched to a depth of, for example, 25 nm.

Thereafter, an n-type semiconductor layer 32 (second n-type semiconductor layer) made of n-GaN is grown again by using an MOVPE apparatus to bury the tunnel junction layer 31.

Subsequently, a semiconductor DBR 35 (second DBR) made of n-AlInN and n-GaN is formed. The semiconductor DBR 35 is made of, for example, 46 pairs of n-AlInN/GaN.

Next, the outer periphery of the wafer was etched to reach the inside of the n-type semiconductor layer 13 to form a surface emitting laser having a columnar mesa structure coaxial with the central axis CX of the tunnel junction layer 31.

Next, the n-electrode 27 was formed on the outer peripheral surface of the n-type semiconductor layer 13. Further, a p-electrode 36 having a diameter larger than that of the tunnel junction layer 31 in a top view (when viewed from a direction perpendicular to the semiconductor DBR 35) and having a circular opening coaxial with the central axis CX was formed on the semiconductor DBR 35.

Further, the back surface of the substrate 11 was polished to form an AR (anti-reflective) coating 29 made of two layers of $Nb_2O_5/SiO_2$. Through the above steps, the formation of the vertical cavity surface emitting laser 10 has been completed.

Although the tunnel junction layer 31 is composed of a $p^+$-GaN layer and an $n^+$-GaN layer, a semiconductor layer having a different composition, such as GaInN and the like, may be used. For example, Mg can be used as an impurity (dopant) in the $p^+$-GaN layer. In addition, it is preferable that the doping concentration of Mg is $4 \times 10^{19}$ cm$^3$ or more. For the $n^+$-GaN layer or the $n^+$-GaInN layer, high doping of $1 \times 10^{18}$ cm$^3$ or more is preferable.

[Correspondence with First Embodiment]

The first and second conditions in the vertical cavity surface emitting laser 50 according to the second embodiment can be considered in the same manner as in the case of the first embodiment.

Specifically, in the vertical cavity surface emitting laser 50 according to the second embodiment, the interface between the semiconductor DBR 35 and the n-type semiconductor layer 32 corresponds to a phase reference (0). With the reference, the antinode is located in the standing wave.

In addition, the n-type semiconductor layer 32 (second n-type semiconductor layer) corresponds to the spacer layer 24 in the first embodiment. More specifically, a portion of the n-type semiconductor layer 32 between the tunnel junction layer 31 and the semiconductor DBR 35 corresponds to the spacer layer 24 in the first embodiment.

Further, the tunnel junction layer 31 corresponds to the transparent conductive film (ITO) 22 in the first embodiment, and it is preferable that there is one node ND of the standing wave SW in the tunnel junction layer 31 ($N_{ND} = 1$).

Further, a condition for the number of nodes ND and antinodes AN of the standing wave SW included in the electron blocking layer 17 and the p-type semiconductor layer 18, which are p regions (first condition) and a condition for the number of nodes ND and antinodes AN included in the final barrier layer 16 (second condition) are the same as those in the first embodiment.

As described in detail above, according to the present invention, it is possible to provide a vertical cavity light-emitting element having a low threshold current and high light emission efficiency.

In the above-described Example, a vertical cavity light-emitting element using a nitride-based semiconductor has been described, but it is also possible to apply the present invention to a vertical cavity light-emitting element using other crystalline semiconductors.

Further, although the semiconductor DBR or the dielectric DBR is illustrated as a reflective mirror constituting a resonator, the present invention is not limited thereto. For example, a single layer reflective mirror or a diffraction grating can also be used.

In addition, the vertical cavity light-emitting element of the present invention has been described as an example of manufacturing by using the MOVPE method, but can be manufactured by using other known crystal growth methods such as molecular beam epitaxy (MBE).

Description of Reference Numerals

10: vertical cavity surface emitting laser
11: substrate
12: reflective mirror (DBR)
13: n-type semiconductor layer
15: active layer
15B: barrier layer
15W: quantum well layer (well layer)
16: final barrier layer (LB)
17: electron blocking layer
18: p-type semiconductor layer
21: insulating film
22: transparent conductive film
24: spacer layer
25: reflective mirror (DBR)
31: tunnel junction layer
31A: p-type semiconductor layer with high impurity concentration
31B: n-type semiconductor layer with high impurity concentration
32: n-type semiconductor layer (second n-type semiconductor layer)
35: semiconductor DBR

**Claims**

1. A vertical cavity light-emitting element comprising:

    a first reflective mirror (12);
    an n-type semiconductor layer (13) formed on the first reflective mirror;
    an active layer (15) that is made of multiple quantum wells (QW1, QW2, QW3, QW4) and formed on the n-type semiconductor layer, and configured to emit light with a wavelength λ;
    a final barrier layer (16) formed on a final quantum well of the active layer;
    an electron blocking layer (17) formed on the final barrier layer;

a p-type semiconductor layer (18) formed on the electron blocking layer;
a dielectric spacer layer (24) formed on the p-type semiconductor layer; and
a second reflective mirror (25) formed on the spacer layer,
wherein

a resonator is configured between the first reflective mirror and the second reflective mirror,
the number of antinodes and the number of nodes of a standing wave due to light emitted from the active layer (15), included in the electron blocking layer (17) and the p-type semiconductor layer (18) is each zero or one, layer thicknesses of the final barrier layer and the active layer are respectively $H_{fb}$ and $H_{qw}$, a refractive index of the final barrier layer is $n_{fb}$, and an equivalent refractive index of the active layer is $n_{qw}$, the following Expression is satisfied for the active layer and the final barrier layer

$$\frac{H_{qw}}{2\left(\dfrac{\lambda}{n_{qw}}\right)} + \frac{H_{fb}}{\left(\dfrac{\lambda}{n_{fb}}\right)} \geq 0.4$$

and
the number of nodes and antinodes of the standing wave included in the final barrier layer (16) is each one or more.

2. The vertical cavity light-emitting element according to claim 1, further comprising:
a transparent conductive film (22) provided between the p-type semiconductor layer (18) and the dielectric spacer layer (24), wherein the transparent conductive film is provided such that there are nodes of the standing wave in the transparent conductive film.

3. The vertical cavity light-emitting element according to claim 1 or 2, wherein
the final barrier layer (16) has the layer thickness of 1/4 or more of an in-medium wavelength $\lambda/n_{fb}$ in the final barrier layer (16) derived from the emission wavelength $\lambda$ of the light generated from the active layer (15).

4. The vertical cavity light-emitting element according to any one of claims 1 to 2, wherein, the number of nodes included in the final barrier layer is 2 or more and the number of antinodes included in the final barrier layer is one or more.

5. The vertical cavity light-emitting element according to any one of claims 1 to 4, wherein the layer thickness of the active layer (15) is 1/8 or less of an in-medium wavelength $\lambda/n_{qw}$ in the active layer derived from the emission wavelength $\lambda$ of the light generated from the active layer.

6. The vertical cavity light-emitting element according to any one of claims 1 to 5, wherein
the vertical cavity light-emitting element has a minimum value of a differential resistance caused by laser oscillation in a vicinity of a threshold current.

7. The vertical cavity light-emitting element according to any one of claims 1 to 6, wherein
the first reflective mirror (12) is a semiconductor distributed bragg reflector, DBR, and the second reflective mirror (25) is a dielectric DBR.

8. A vertical cavity light-emitting element comprising:

a first reflective mirror (12);
a first n-type semiconductor layer (13) formed on the first reflective mirror;
an active layer (15) that is made of multiple quantum wells (QW1, QW2, QW3, QW4) and formed on the n-type semiconductor layer, and is configured to emit light with a wavelength $\lambda$;
a final barrier layer (16) formed on a final quantum well (QW4) of the active layer;
an electron blocking layer (17) formed on the final barrier layer;
a p-type semiconductor layer (18) formed on the electron blocking layer;
a tunnel junction layer (31) as a current confinement layer formed on the p-type semiconductor layer;
a second n-type semiconductor layer (32) formed by burying the tunnel junction layer; and
a second reflective mirror (35) formed on the second n-type semiconductor layer,
wherein

a resonator is configured between the first reflective mirror (12) and the second reflective mirror (35), the number of antinodes and the number of nodes of a standing wave due to light emitted from the active layer, included in the electron blocking layer and the p-type semiconductor layer is each zero or one, layer thicknesses of the final barrier layer and the active layer are respectively $H_{fb}$ and $H_{qw}$, a refractive index of the final barrier layer is $n_{fb}$, and an equivalent refractive index of the active layer is $n_{qw}$, the following Expression is satisfied for the active layer and the final barrier layer

$$\frac{H_{qw}}{2\left(\frac{\lambda}{n_{qw}}\right)} + \frac{H_{fb}}{\left(\frac{\lambda}{n_{fb}}\right)} \geq 0.4$$

, and
the number of nodes and antinodes of the standing wave included in the final barrier layer is one or more, respectively.

9. The vertical cavity light-emitting element according to claim 8, wherein, the tunnel junction layer is provided such that there are nodes of the standing waves in the tunnel junction layer.

10. The vertical cavity light-emitting element according to any one of claims 8 to 9, wherein the final barrier layer has the layer thickness of 1/4 or more of an in-medium wavelength $\lambda/n_{fb}$ in the final barrier layer derived from the emission wavelength $\lambda$ of the light generated from the active layer.

11. The vertical cavity light-emitting element according to any one of claims 8 to 9, wherein, the number of nodes included in the final barrier layer is 2 or more and the number of antinodes included in the final barrier layer is one or more.

12. The vertical cavity light-emitting element according to any one of claims 8 to 11, wherein the layer thickness of the active layer (15) is 1/8 or less of an in-medium wavelength $\lambda/n_{qw}$ in the active layer derived from the emission wavelength $\lambda$ of the light generated from the active layer.

13. The vertical cavity light-emitting element according to any one of claims 8 to 12, wherein the vertical cavity light-emitting element has a minimum value of a differential resistance caused by laser oscillation in a vicinity of a threshold current.

14. The vertical cavity light-emitting element according to any one of claims 8 to 13, wherein the first reflective mirror (12) and the second reflective mirror (35) are semiconductor DBRs.

**Patentansprüche**

1. Lichtemittierendes Element mit vertikalem Hohlraum bzw. Oberflächenemitterelement, das Folgendes aufweist:

einen ersten reflektierenden Spiegel (12);
eine Halbleiterschicht (13) vom n-Typ, die auf dem ersten reflektierenden Spiegel ausgebildet ist;
eine aktive Schicht (15), die aus mehreren Quantentöpfen (QW1, QW2, QW3, QW4) besteht und auf der Halbleiterschicht vom n-Typ ausgebildet ist und so konfiguriert ist, dass sie Licht mit einer Wellenlänge $\lambda$ emittiert;
eine abschließende Sperrschicht (16), die auf einem abschließenden Quantentopf der aktiven Schicht ausgebildet ist;
eine Elektronensperrschicht (17), die auf der abschließenden Sperrschicht ausgebildet ist;
eine Halbleiterschicht (18) vom p-Typ, die auf der Elektronensperrschicht ausgebildet ist;
eine dielektrische Abstandsschicht (24), die auf der Halbleiterschicht vom p-Typ ausgebildet ist; und
einen zweiten reflektierenden Spiegel (25), der auf der Abstandsschicht ausgebildet ist,
wobei
ein Resonator zwischen dem ersten reflektierenden Spiegel und dem zweiten reflektierenden Spiegel konfiguriert ist,
die Anzahl der Anti-Knoten und die Anzahl der Knoten einer stehenden Welle aufgrund von Licht, das von der aktiven Schicht (15) emittiert wird, die in der Elektronensperrschicht (17) und der Halbleiterschicht (18) vom p-Typ enthalten ist, jeweils null oder eins ist,

die Schichtdicken der abschließenden Sperrschicht und der aktiven Schicht sind $H_{fb}$ bzw. $H_{qw}$ sind, ein Brechungsindex der abschließenden Sperrschicht $n_{fb}$ ist und ein äquivalenter Brechungsindex der aktiven Schicht $n_{qw}$ ist,

der folgende Ausdruck für die aktive Schicht und die abschließende Sperrschicht gilt

$$\frac{H_{qw}}{2\left(\frac{\lambda}{n_{qw}}\right)} + \frac{H_{fb}}{\left(\frac{\lambda}{n_{fb}}\right)} \geq 0.4$$

und

die Anzahl der Knoten und Anti-Knoten der stehenden Welle, die in der abschließenden Sperrschicht (16) enthalten sind, jeweils eins oder mehr ist.

2. Lichtemittierendes Element mit vertikalem Hohlraum bzw. Oberflächenemitterelement nach Anspruch 1, das weiter Folgendes aufweist: einen transparenten leitenden Film (22), der zwischen der Halbleiterschicht (18) vom p-Typ und der dielektrischen Abstandsschicht (24) vorgesehen ist, wobei der transparente leitende Film so vorgesehen ist, dass es Knoten der stehenden Welle in dem transparenten leitenden Film gibt.

3. Lichtemittierendes Element mit vertikalem Hohlraum bzw. Oberflächenemitterelement nach Anspruch 1 oder 2, wobei die abschließende Sperrschicht (16) eine Schichtdicke von 1/4 oder mehr einer In-Medium-Wellenlänge $\lambda/n_{fb}$ in der abschließenden Sperrschicht (16) aufweist, die von der Emissionswellenlänge $\lambda$ des von der aktiven Schicht (15) erzeugten Lichts abgeleitet ist.

4. Lichtemittierendes Element mit vertikalem Hohlraum bzw. Oberflächenemitterelement nach einem der Ansprüche 1 bis 2, wobei die Anzahl der in der abschließenden Sperrschicht enthaltenen Knotenpunkte zwei oder mehr und die Anzahl der in der abschließenden Sperrschicht enthaltenen Anti-Knotenpunkte eins oder mehr beträgt.

5. Lichtemittierendes Element mit vertikalem Hohlraum bzw. Oberflächenemitterelement nach einem der Ansprüche 1 bis 4, wobei die Schichtdicke der aktiven Schicht (15) 1/8 oder weniger einer In-Medium-Wellenlänge $\lambda/n_{fb}$ in der aktiven Schicht beträgt, die von der Emissionswellenlänge A des von der aktiven Schicht erzeugten Lichts abgeleitet ist.

6. Lichtemittierendes Element mit vertikalem Hohlraum bzw. Oberflächenemitterelement nach einem der Ansprüche 1 bis 5, wobei das Oberflächenemitterelement einen minimalen Wert eines differentiellen Widerstands aufweist, der durch Laseroszillation in der Nähe eines Schwellenstroms verursacht wird.

7. Lichtemittierendes Element mit vertikalem Hohlraum bzw. Oberflächenemitterelement nach einem der Ansprüche 1 bis 6, wobei der erste reflektierende Spiegel (12) ein verteilter Halbleiter-Bragg-Reflektor, DBR, ist und der zweite reflektierende Spiegel (25) ein dielektrischer DBR ist.

8. Lichtemittierendes Element mit vertikalem Hohlraum bzw. Oberflächenemitterelement, das Folgendes aufweist:

einen ersten reflektierenden Spiegel (12);
eine erste Halbleiterschicht (13) vom n-Typ, die auf dem ersten reflektierenden Spiegel ausgebildet ist;
eine aktive Schicht (15), die aus mehreren Quantentöpfen (QW1, QW2, QW3, QW4) besteht und auf der Halbleiterschicht vom n-Typ ausgebildet ist, und die so konfiguriert ist, dass sie Licht mit einer Wellenlänge $\lambda$ emittiert;
eine abschließende Sperrschicht (16), die auf einem abschließenden Quantentopf (QW4) der aktiven Schicht ausgebildet ist,
eine Elektronensperrschicht (17), die auf der abschließenden Sperrschicht ausgebildet ist;
eine Halbleiterschicht (18) vom p-Typ, die auf der Elektronensperrschicht ausgebildet ist;
eine Tunnel-Junction- bzw. Tunnelübergangsschicht (31) als Strombegrenzungsschicht, die auf der Halbleiterschicht vom p-Typ ausgebildet ist;
eine zweite Halbleiterschicht (32) vom n-Typ, die durch Bedecken der Tunnelübergangsschicht gebildet wird; und
einen zweiten reflektierenden Spiegel (35), der auf der zweiten Halbleiterschicht vom n-Typ gebildet ist,
wobei

ein Resonator zwischen dem ersten reflektierenden Spiegel (12) und dem zweiten reflektierenden Spiegel (35) konfiguriert ist,

die Anzahl der Anti-Knoten und die Anzahl der Knoten einer stehenden Welle aufgrund von Licht, das von der aktiven Schicht emittiert wird, die in der Elektronensperrschicht und der Halbleiterschicht vom p-Typ enthalten ist, jeweils null oder eins ist,

die Schichtdicken der abschließenden Sperrschicht und der aktiven Schicht $H_{fb}$ bzw. $H_{qw}$ sind, ein Brechungsindex der abschließenden Sperrschicht $n_{fb}$ ist, und ein äquivalenter Brechungsindex der aktiven Schicht $n_{qw}$ ist, der folgende Ausdruck für die aktive Schicht und die abschließende Sperrschicht gilt

$$\frac{H_{qw}}{2\left(\frac{\lambda}{n_{qw}}\right)} + \frac{H_{fb}}{\left(\frac{\lambda}{n_{fb}}\right)} \geq 0.4$$

und

die Anzahl der Knoten und Anti-Knoten der stehenden Welle, die in der abschließenden Sperrschicht enthalten sind, eins oder größer ist.

9. Lichtemittierendes Element mit vertikalem Hohlraum bzw. Oberflächenemitterelement nach Anspruch 8, wobei die Tunnel-Junction- bzw. Tunnelübergangsschicht so vorgesehen ist, dass es Knoten der stehenden Wellen in der Tunnelübergangsschicht gibt.

10. Lichtemittierendes Element mit vertikalem Hohlraum bzw. Oberflächenemitterelement nach einem der Ansprüche 8 bis 9, wobei die abschließende Sperrschicht eine Schichtdicke von 1/4 oder mehr einer In-Medium-Wellenlänge $\lambda/n_{fb}$ in der abschließenden Sperrschicht aufweist, die von der Emissionswellenlänge A des von der aktiven Schicht erzeugten Lichts abgeleitet ist.

11. Lichtemittierendes Element mit vertikalem Hohlraum bzw. Oberflächenemitterelement nach einem der Ansprüche 8 bis 9, wobei die Anzahl der in der abschließenden Sperrschicht enthaltenen Knoten zwei oder mehr beträgt und die Anzahl der in der abschließenden Sperrschicht enthaltenen Anti-Knoten eins oder mehr beträgt.

12. Lichtemittierendes Element mit vertikalem Hohlraum bzw. Oberflächenemitterelement nach einem der Ansprüche 8 bis 11, wobei die Schichtdicke der aktiven Schicht (15) 1/8 oder weniger einer In-Medium-Wellenlänge $\lambda/n_{qw}$ in der aktiven Schicht beträgt, die von der Emissionswellenlänge $\lambda$ des von der aktiven Schicht erzeugten Lichts abgeleitet ist.

13. Lichtemittierendes Element mit vertikalem Hohlraum bzw. Oberflächenemitterelement nach einem der Ansprüche 8 bis 12, wobei das lichtemittierende Element mit vertikalem Hohlraum einen minimalen Wert eines durch Laserschwingung verursachten differentiellen Widerstands in der Nähe eines Schwellenstroms aufweist.

14. Lichtemittierendes Element mit vertikalem Hohlraum bzw. Oberflächenemitterelement nach einem der Ansprüche 8 bis 13, wobei der erste reflektierende Spiegel (12) und der zweite reflektierende Spiegel (35) Halbleiter-DBR sind.

**Revendications**

1. Élément électroluminescent à cavité verticale comprenant :

un premier miroir réfléchissant (12) ;
une couche semiconductrice de type n (13) formée sur le premier miroir réfléchissant ;
une couche active (15) constituée de plusieurs puits quantiques (QW1, QW2, QW3, QW4) et formée sur la couche semiconductrice de type n, et configurée pour émettre de la lumière à une longueur d'onde $\lambda$ ;
une couche barrière finale (16) formée sur un puits quantique final de la couche active ;
une couche de blocage d'électrons (17) formée sur la couche barrière finale ;
une couche semiconductrice de type p (18) formée sur la couche de blocage d'électrons ;
une couche d'espaceur diélectrique (24) formée sur la couche semiconductrice de type p ; et
un deuxième miroir réfléchissant (25) formé sur la couche d'espaceur,
dans lequel

un résonateur est configuré entre le premier miroir réfléchissant et le deuxième miroir réfléchissant ;
le nombre d'anti-nœuds et le nombre de nœuds d'une onde stationnaire due à la lumière émise par la couche active (15), inclus dans la couche de blocage d'électrons (17) et la couche semiconductrice de type p (18) sont chacun nuls ou un,
les épaisseurs de couche de la couche barrière finale et de la couche active sont respectivement $H_{fb}$ et $H_{qw}$, un indice de réfraction de la couche barrière finale est $n_{fb}$, et un indice de réfraction équivalent de la couche active est $n_{qw}$,

l'expression suivante est satisfaite pour la couche active et la couche barrière finale

$$\frac{H_{qw}}{2\left(\frac{\lambda}{n_{qw}}\right)} + \frac{H_{fb}}{\left(\frac{\lambda}{n_{fb}}\right)} \geq 0,4$$

et
le nombre de nœuds et d'anti-nœuds de l'onde stationnaire inclus dans la couche barrière finale (16) est chacun égal à un ou plus.

2. Élément électroluminescent à cavité verticale selon la revendication 1, comprenant en outre :
un film conducteur transparent (22) prévu entre la couche semiconductrice de type p (18) et la couche d'espaceur diélectrique (24), dans lequel le film conducteur transparent est prévu de sorte qu'il y ait des nœuds de l'onde stationnaire dans le film conducteur transparent.

3. Élément électroluminescent à cavité verticale selon la revendication 1 ou 2, dans lequel
la couche barrière finale (16) a une épaisseur de couche de 1/4 ou plus d'une longueur d'onde dans le milieu $\lambda/n_{fb}$ dans la couche barrière finale (16) obtenue à partir de la longueur d'onde d'émission $\lambda$ de la lumière générée par la couche active (15).

4. Élément électroluminescent à cavité verticale selon l'une quelconque des revendications 1 à 2, dans lequel le nombre de nœuds inclus dans la couche barrière finale est de 2 ou plus et le nombre d'anti-nœuds inclus dans la couche barrière finale est de un ou plus.

5. Élément électroluminescent à cavité verticale selon l'une quelconque des revendications 1 à 4, dans lequel l'épaisseur de couche de la couche active (15) est de 1/8 ou moins d'une longueur d'onde dans le milieu $\lambda/n_{qw}$ dans la couche active obtenue à partir de la longueur d'onde d'émission $\lambda$ de la lumière générée par la couche active.

6. Élément électroluminescent à cavité verticale selon l'une quelconque des revendications 1 à 5, dans lequel l'élément électroluminescent à cavité verticale a une valeur minimale d'une résistance différentielle provoquée par une oscillation laser à proximité d'un courant de seuil.

7. Élément électroluminescent à cavité verticale selon l'une quelconque des revendications 1 à 6, dans lequel le premier miroir réfléchissant (12) est un réflecteur de Bragg distribué à semiconducteur, DBR, et le deuxième miroir réfléchissant (25) est un DBR diélectrique.

8. Élément électroluminescent à cavité verticale comprenant :

un premier miroir réfléchissant (12) ;
une première couche semiconductrice de type n (13) formée sur le premier miroir réfléchissant ;
une couche active (15) constituée de plusieurs puits quantiques (QW1, QW2, QW3, QW4) et formée sur la couche semiconductrice de type n, et configurée pour émettre de la lumière à une longueur d'onde $\lambda$ ;
une couche barrière finale (16) formée sur un puits quantique final (QW4) de la couche active ;
une couche de blocage d'électrons (17) formée sur la couche barrière finale ;
une couche semiconductrice de type p (18) formée sur la couche de blocage d'électrons ;
une couche de jonction tunnel (31) en tant que couche de confinement de courant formée sur la couche semiconductrice de type p ;
une deuxième couche semiconductrice de type n (32) formée en enterrant la couche de jonction tunnel ; et
un deuxième miroir réfléchissant (35) formé sur la deuxième couche semiconductrice de type n,

dans lequel

un résonateur est configuré entre le premier miroir réfléchissant (12) et le deuxième miroir réfléchissant (35), le nombre d'anti-nœuds et le nombre de nœuds d'une onde stationnaire due à la lumière émise par la couche active, inclus dans la couche de blocage d'électrons et la couche semiconductrice de type p sont chacun nuls ou un,
les épaisseurs de couche de la couche barrière finale et de la couche active sont respectivement $H_{fb}$ et $H_{qw}$, un indice de réfraction de la couche barrière finale est $n_{fb}$, et un indice de réfraction équivalent de la couche active est $n_{qw}$,

l'expression suivante est satisfaite pour la couche active et la couche barrière finale

$$\frac{H_{qw}}{2\left(\frac{\lambda}{n_{qw}}\right)} + \frac{H_{fb}}{\left(\frac{\lambda}{n_{fb}}\right)} \geq 0{,}4,$$

et
le nombre de nœuds et d'anti-nœuds de l'onde stationnaire inclus dans la couche barrière finale est chacun égal à un ou plus, respectivement.

9. Élément électroluminescent à cavité verticale selon la revendication 8, dans lequel
la couche de jonction tunnel est prévue de sorte qu'il y ait des nœuds des ondes stationnaires dans la couche de jonction tunnel.

10. Élément électroluminescent à cavité verticale selon l'une quelconque des revendications 8 à 9, dans lequel la couche barrière finale a une épaisseur de couche de 1/4 ou plus d'une longueur d'onde dans le milieu $\lambda/n_{fb}$ dans la couche barrière finale obtenue à partir de la longueur d'onde d'émission $\lambda$ de la lumière générée par la couche active.

11. Élément électroluminescent à cavité verticale selon l'une quelconque des revendications 8 à 9, dans lequel le nombre de nœuds inclus dans la couche barrière finale est de 2 ou plus et le nombre d'anti-nœuds inclus dans la couche barrière finale est de un ou plus.

12. Élément électroluminescent à cavité verticale selon l'une quelconque des revendications 8 à 11, dans lequel l'épaisseur de couche de la couche active (15) est de 1/8 ou moins d'une longueur d'onde dans le milieu $\lambda/nqw$ dans la couche active obtenue à partir de la longueur d'onde d'émission $\lambda$ de la lumière générée par la couche active.

13. Élément électroluminescent à cavité verticale selon l'une quelconque des revendications 8 à 12, dans lequel l'élément électroluminescent à cavité verticale a une valeur minimale d'une résistance différentielle provoquée par une oscillation laser à proximité d'un courant de seuil.

14. Élément électroluminescent à cavité verticale selon l'une quelconque des revendications 8 à 12, dans lequel le premier miroir réfléchissant (12) et le deuxième miroir réfléchissant (25) sont des DBR semiconducteurs.

# FIG.1

# FIG.2

## FIG.3

[Ex.1]

| 14 | 15 | 16 | 17 | 18 | 22 | 24 | 25 |

15WL(QW4)  LB(GaN)      p-AlGaN  p-GaN   ITO  Nb₂O₅

AN

ND    SW

AN    ND    ND    AN

AN    A

## FIG.4

[Cmp.1]

| 14 | 15 16 17 | 18 | 22 | 24 | 25 |

15WL
(QW4)   LB(GaN) p-AlGaN
                p-GaN        ITO Nb₂O₅

SW

AN

ND    ND    ND    AN

AN    A

## FIG.5

[Table ]

| LAYER | Ex. 1 THICKNESS (nm) | $N_{ND}, N_{AN}$ | Ex. 2 THICKNESS (nm) | $N_{ND}, N_{AN}$ | Ex. 3 THICKNESS (nm) | $N_{ND}, N_{AN}$ | Cmp. 1 THICKNESS (nm) | $N_{ND}, N_{AN}$ | Cmp. 2 THICKNESS (nm) | $N_{ND}, N_{AN}$ |
|---|---|---|---|---|---|---|---|---|---|---|
| $Nb_2O_5$ | 38 | | 38 | | 38 | | 38 | | 38 | |
| ITO | 20 | $N_{ND}=1$ | 20 | $N_{ND}=1$ | 20 | $N_{ND}=1$ | 20 | $N_{ND}=1$ | 20 | $N_{ND}=1$ |
| p-GaN | 83 | $N_{ND}=1$ $N_{AN}=1$ | 45 | $N_{ND}=0$ $N_{AN}=1$ | 81 | $N_{ND}=0$ $N_{AN}=1$ | 92 | $N_{ND}=1$ $N_{AN}=1$ | 387 | $N_{ND}=4$ $N_{AN}=4$ |
| EBL | 10 | | 20 | | 20 | $N_{ND}=1$ | 10 | | 10 | |
| FINAL BARRIER | 120 | $N_{ND}=1$ $N_{AN}=1$ | 70 | $N_{ND}=1$ $N_{AN}=1$ | 220 | $N_{ND}=2$ $N_{AN}=2$ | 10 | $N_{ND}=0$ $N_{AN}=0$ | 120 | $N_{ND}=1$ $N_{AN}=2$ |
| QW4 | 3 | | 3 | | 3 | | 3 | | 3 | |
| BR1-4 | 4 | | 4 | | 4 | | 4 | | 4 | |
| QW1-3 | 3 | $N_{AN}=1$ (QW2) | 3 | | 3 | | 3 | $N_{AN}=1$ (QW2) | 3 | |

EP 4 387 017 B1

# FIG.6A

[Ex.1]

# FIG.6B

[Ex.1]

# FIG.6C

[Ex.1]

## FIG.7A

[Cmp.1]

## FIG.7B

[Cmp.1]

## FIG.7C

[Cmp.1]

## FIG.8A

[Ex.1]

## FIG.8B

[Cmp.1]

# FIG.9

[Ex.2]

# FIG.10A

# FIG.10B

# FIG.11

FIG.12

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2014131019 A
- JP 2009194102 A
- JP 2011029607 A
- US 2002150135 A1

**Non-patent literature cited in the description**

- Nonpolar GaN-based VCSELs with lattice-matched nanoporous distributed Bragg reflector mirrors. **MISHKAT-UL-MASABIH SAADAT M**. SPIE PROCEEDINGS. SPIE, 16 February 2020, vol. 11280, 112800I-112800I

- Metalized monolithic high-contrast grating as a mirror for GaN-based VCSELs. **SARZALA ROBERT P et al.** PROCEEDINGS OF SPIE; [PROCEEDINGS OF SPIE ISSN 0277-786X VOLUME 10524. SPIE, 23 February 2018, vol. 10532, 105321B-105321B